# EUROPÄISCHE PATENTANMELDUNG

(11) **EP 2 219 218 A2**
(43) Veröffentlichungstag der Anmeldung: **18.08.2010**
(21) Anmeldenummer: 09016023.5
(22) Anmeldetag: 24.12.2009
(51) Int. Cl.: H01L 23/373

(54) **Baugruppe und Verfahren zur Herstellung einer Baugruppe**

(30) Priorität: 16.02.2009 DE 102009000886
(71) Anmelder: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(57) **Zusammenfassung**

Die Erfindung betrifft eine Baugruppe, bei der eine Wärmeableitfläche (7) eines Halbleitermoduls (10), insbesondere eines Leistungshalbleitermoduls, unter Zwischenschaltung einer wärmeleitenden Ausgleichsschicht (5) mit einer Kontaktfläche (4) eines Kühlkörpers (3) verbunden ist. Zur Verbesserung der Leistungsfähigkeit der Baugruppe wird erfindungsgemäß vorgeschlagen, dass die wärmeleitende Ausgleichsschicht (5) eine aus einem präkeramischen Polymer gebildete Matrix aufweist.

## Beschreibung

Die Erfindung betrifft eine Baugruppe nach dem Oberbegriff des Anspruchs 1. Sie betrifft ferner ein Verfahren zur Herstellung einer solchen Baugruppe.

Eine solche Baugruppe ist beispielsweise aus der DE 103 43 502 A1 bekannt. Bei der bekannten Baugruppe ist eine Wärmeableitfläche eines Halbleiters unter Zwischenschaltung einer Wärmeleitpaste mit einer Kontaktfläche eines Kühlkörpers verbunden. Herkömmliche Wärmeleitpasten bestehen meist aus einem Silikonöl und einem oxidischen Keramikpulver. Die Wärmeleitfähigkeit λ solcher Wärmeleitpasten liegt unter 10 W/mK. Sie bilden eine thermische Barriere zwischen der Wärmeableitfläche und der Kontaktfläche des Kühlkörpers. Um die Wirkung dieser thermischen Barriere möglichst gering zu halten, wird nach dem Stand der Technik stets versucht, die Wärmeleitpaste mit einer geringen Schichtdicke von < 20 µm aufzubringen. Zur Realisierung einer solchen geringen Schichtdicke ist es allerdings erforderlich, sowohl die Oberfläche der Wärmeableitfläche als auch die Kontaktfläche des Kühlkörpers in einer entsprechend hohen Qualität herzustellen. Das ist aufwändig. Ein weiterer Nachteil der bekannten Wärmeleitpaste besteht darin, dass diese nicht ausgehärtet werden kann. Infolgedessen ist es erforderlich, den Halbleiter zusätzlich mit dem Kühlkörper mechanisch zu verbinden. Die bekannte Wärmeleitpaste weist eine relativ hohe Viskosität auf. Infolgedessen kann sie in der Praxis nicht immer in der gewünschten Homogenität über die zu verbindenden Flächen verteilt werden.

Aufgabe der Erfindung ist es, die Nachteile nach dem Stand der Technik zu beseitigen. Es soll insbesondere eine möglichst einfach herstellbare Baugruppe mit verbesserter Leistungsfähigkeit angegeben werden. Ein weiteres Ziel der Erfindung besteht in der Angabe eines Verfahrens zur Herstellung einer solchen Baugruppe.

Diese Aufgabe wird durch die Merkmale der Ansprüche 1 und 10 gelöst. Zweckmäßige Ausgestaltungen der Erfindung ergeben sich aus den Merkmalen der Ansprüche 2 bis 9 und 11 bis 18.

Nach Maßgabe der Erfindung ist vorgesehen, dass die wärmeleitende Ausgleichsschicht eine aus einem präkeramischen Polymer gebildete Matrix aufweist. - Die erfindungsgemäß vorgeschlagene wärmeleitende Ausgleichsschicht zeichnet sich durch eine erheblich verbesserte Wärmeleitfähigkeit λ aus. Sie weist zunächst eine niedrige Viskosität auf und lässt sich infolgedessen problemlos homogen über die zu verbindenden Flächen verteilen. Ein weiterer wesentlicher Vorteil der vorgeschlagenen wärmeleitende Ausgleichsschicht besteht darin, dass diese nach dem Auftragen auf die zu verbindenden Flächen beispielsweise durch eine Temperaturbehandlung zunächst in einen gelartigen und nachfolgend in eine duroplastischen Zustand überführt werden kann. Damit ist es möglich, das Halbleitermodul mit der Kontaktfläche des Kühlkörpers zu verkleben. Das Vorsehen zusätzlicher mechanischer Befestigungsmittel kann entfallen. Wegen der verbesserten Wärmeleitfähigkeit λ der vorgeschlagenen wärmeleitenden Ausgleichsschicht ist es nicht mehr unbedingt erforderlich, diese in einer besonders dünnen Schichtstärke aufzubringen. Das vereinfacht insgesamt die Herstellung der Baugruppe.

Unter dem Begriff "präkeramisches Polymer" wird ein Polymer verstanden, welches z. B. mit zunehmender Temperatur zunächst in einen gelartigen und nachfolgend in einen duroplastischen Zustand übergeht. Im duroplastischen Zustand weist ein präkeramisches Polymer im Dauereinsatz in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosilizane.

Bei der "Wärmeableitfläche" kann es sich um eine der Kontaktfläche des Kühlkörpers zugewandte Unterseite eines Halbleiters handeln. Es kann aber auch sein, dass die Wärmeableitfläche Bestandteil einer aus Metall, vorzugsweise aus Kupfer oder einer Kupferlegierung, hergestellten Wärmeableitplatte ist, welche mit dem Halbleiter verbunden ist. Insbesondere herkömmliche Leistungshalbleiter sind mit einer solchen Wärmeableitplatte versehen.

Nach einer vorteilhaften Ausgestaltung ist vorgesehen, dass zumindest ein Halbleiter, vorzugsweise ein Leistungshalbleiter, mittels eines weiteren präkeramischen Polymers auf einer der wärmeableitenden Ausgleichsschicht abgewandten Oberseite der Wärmeableitplatte befestigt ist. D. h. es kann auch zur Montage des Halbleitermoduls, nämlich zum Anbringen der Wärmeableitplatte am Halbleiter, ein präkeramisches Polymer verwendet werden.

Des Weiteren hat es sich als zweckmäßig erwiesen, dass das präkeramische Polymer und/oder das weitere präkeramische Polymer mit einem Füllgrad von bis zu 80 Vol.% mit einem Füllstoff gefüllt ist. Damit lassen sich insbesondere die Fließeigenschaften einstellen.

Zweckmäßigerweise handelt es sich bei dem Füllstoff um ein aus einem keramischen Material gebildetes Pulver mit einer mittleren Korngröße im Bereich von 0,5 bis 500 µm. Das vorgeschlagene keramische Material ist weitgehend inert. Dessen Zusatz führt nicht zu unerwünschten chemischen Reaktionen. Die vorgeschlagene mittlere Korngröße ermöglicht eine Applikation der präkeramischen Polymere mit herkömmlichen Applikationsmitteln, beispielsweise Nadeldispenser, Siebdruck, Jet oder dgl.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit des mit dem keramischen Material gefüllten präkeramischen Polymers bzw. weiteren präkeramischen Polymers auf Werte oberhalb 2 W/mK, insbesondere oberhalb 10 W/mK, zu steigern. Damit eignet sich das vorgeschlagene Material insbesondere zur Herstellung einer im Betrieb eine relativ große Wärmemenge freisetzenden Leistungshalbleiteranordnung.

Das keramische Material ist zweckmäßigerweise aus der folgenden Gruppe ausgewählt: BN, SiC, Si₃N₄, AlN, Steatit, Cordierit. Die vorgeschlagenen keramischen Materialien zeichnen sich durch eine hohe Wärmeleitfähigkeit aus.

Das präkeramische Polymer und/oder das weitere präkeramische Polymer liegt zweckmäßigerweise in gelartiger oder duroplastischer Form vor. Die jeweils gewünschte Form wird durch den Vernetzungsgrad bestimmt. Der Vernetzungsgrad wiederum kann beispielsweise durch Zufuhr von thermischer Energie, Strahlungsenergie oder dgl. eingestellt werden. Damit kann die Härte und die Steifigkeit des präkeramischen bzw. des weiteren präkeramischen Polymers den jeweiligen Anforderungen angepasst werden. Es weist in beiden Formen eine hohe Haftkraft auf Metallen, insbesondere auf Aluminium oder Kupfer auf, wodurch ein besonders fester Verbund mit einer Wärmeableitplatte und/oder einem Kühlkörper erreicht werden kann.

Es hat sich als zweckmäßig erwiesen, das präkeramische Polymer aus der folgenden Gruppe auszuwählen: Polysiloxan, Polysilazan, Polycarbosilan. Die vorgenannten Materialien weisen im Dauerbetrieb eine hervorragende Temperaturbeständigkeit bis zu Temperaturen im Bereich von 300°C auf.

Nach weiterer Maßgabe der Erfindung wird ein Verfahren zur Herstellung einer Baugruppe vorgeschlagen, bei der ein Halbleitermodul, insbesondere ein Leistungshalbleitermodul, mit einem Kühlkörper verbunden ist, mit folgenden Schritten:

Auftragen eines fließfähigen präkeramischen Polymers auf eine Kontaktfläche des Kühlkörpers und/oder auf eine Wärmeableitfläche des Halbleitermoduls,

Verbinden der Wärmeableitfläche mit der Kontaktfläche, so dass sich dazwischen eine aus dem präkeramischen Polymer gebildete durchgehende Ausgleichsschicht ausbildet und

Vernetzen des präkeramischen Polymers, so dass dessen Viskosität sich zumindest um den Faktor 2 erhöht.

Nach dem vorgeschlagenen Verfahren wird beim Auftragen ein "fließfähiges präkeramische Polymer" verwendet. Dessen Viskosität ist insbesondere so gewählt, dass es mit herkömmlichen Applikationsmitteln, beispielsweise Nadeldispenser, Jet, Siebdruck oder dgl. homogen auf die zu verbindenden Flächen aufgetragen werden kann. Infolgedessen bildet sich aus dem präkeramischen Polymer nach dem Verbinden der Wärmeableitfläche mit der Kontaktfläche eine durchgehende Ausgleichsschicht. Die Ausgleichsschicht gleicht Unebenheiten an der Oberfläche der Wärmeableitfläche und/oder Kontaktfläche aus. Sie ermöglicht damit über die gesamte Wärmeableitfläche hinweg eine ununterbrochene Wärmeableitung durch die Ausgleichsschicht hindurch zum Kühlkörper. Die Viskosität der Ausgleichsschicht kann nach der Montage z. B. durch Zufuhr von thermischer Energie zumindest um den Faktor 2, vorzugsweise zumindest um den Faktor 10, 20 oder 50 erhöht werden. Mit der Ausgleichsschicht kann das Halbleitermodul mit dem Kühlkörper verklebt werden.

Wegen der vorteilhaften Ausgestaltungen des Verfahrens wird auf die vorangegangenen Ausführungen verwiesen. Die dort erläuterten Merkmale können vorteilhafte Ausgestaltungen, insbesondere Verwendungen, im Zusammenhang mit dem vorgeschlagenen Verfahren bilden.

Nachfolgend werden Ausführungsbeispiele der Erfindung anhand der Zeichnungen näher erläutert. Es zeigen:
- Fig. 1: eine schematische Teilquerschnittsansicht durch eine erste Baugruppe und
- Fig. 2: eine schematische Teilquerschnittsansicht durch eine zweite Baugruppe.

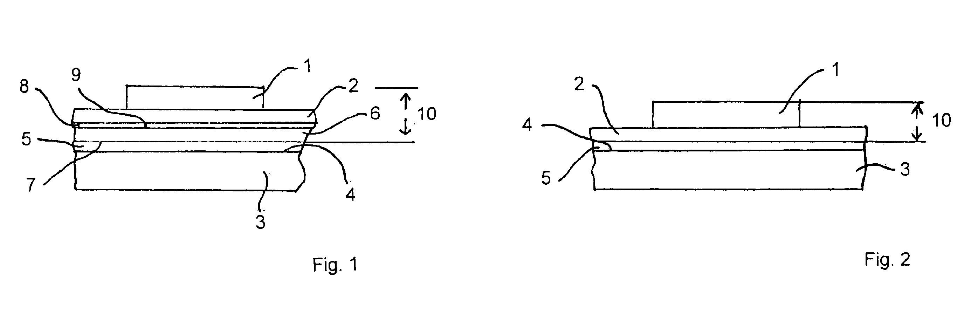

Bei der in Fig. 1 gezeigten schematischen Teilquerschnittsansicht ist ein mit dem Bezugszeichen 1 bezeichneter Leistungshalbleiter, beispielsweise eine Leistungsdiode, ein Leistungstransistor oder dgl., auf einem Substrat 2 montiert. Bei dem Substrat kann es sich z. B. um ein herkömmliches DCB-Substrat oder dgl. handeln. Mit dem Bezugszeichen 3 ist ein Kühlkörper bezeichnet, der beispielsweise aus einer Aluminium- oder Kupferlegierung hergestellt sein kann. Auf eine Kontaktfläche 4 des Kühlkörpers 3 ist unter Zwischenschaltung einer wärmeleitenden Ausgleichsschicht 5 eine Wärmeableitplatte 6 montiert. Die Wärmeableitplatte 6 ist beispielsweise aus Kupfer oder einer Kupferlegierung hergestellt. Mit dem Bezugszeichen 7 ist eine dem Kühlkörper 3 zugewandte Wärmeableitfläche der Wärmeableitplatte 6 bezeichnet. Die Wärmeableitplatte 6 ist mittels einer Verbindungsschicht 8 mit dem Substrat 2 verbunden. Dabei ist eine Oberseite 9 der Wärmeableitplatte 6 dem Substrat 2 zugewandt.

Die Ausgleichsschicht 5 ist erfindungsgemäß aus einem präkeramischen Polymer gebildet, welches beispielsweise mit einem Füllgrad von 50 bis 75 Vol.% mit einem SiC-Pulver mit einer mittleren Korngröße im Bereich von 1 bis 5 µm gefüllt sein kann. Das gefüllte präkeramische Polymer wird nach der Montage des allgemein mit dem Bezugszeichen 10 bezeichneten Halbleitermoduls beispielsweise durch Zufuhr thermischer Energie vernetzt, bis es in einem duroplastischen Zustand vorliegt. In diesem Zustand weist das präkeramische Polymer abgesehen von einer hervorragenden Wärmeleitfähigkeit λ von mehr als 10 W/mK eine exzellente Temperaturbeständigkeit bis zu einer Temperatur von 300°C auf.

Bei herkömmlichen Halbleitermodulen, insbesondere Leistungshalbleitermodulen, ist das Substrat 2 üblicherweise mittels eines Lots mit der Wärmeableitplatte 6 verbunden. Nach einer Ausgestaltung der Erfindung ist vorgesehen, dass anstelle der aus dem Lot gebildeten Verbindungsschicht eine aus einem weiteren präkeramischen Polymer hergestellte Verbindungsschicht eingesetzt wird. Dabei kann das weitere präkeramische Polymer ähnlich wie das präkeramische Polymer mit einem Füllstoff versehen sein. Auch das weitere präkeramische Polymer kann nach der Montage der Wärmeableitplatte 6 in einen duroplastischen Zustand versetzt werden. Sowohl das präkeramische Polymer als auch das weitere präkeramische Polymer können beispielsweise aus Polysiloxan hergestellt sein.

Fig. 2 zeigt eine schematische Schnittansicht durch eine zweite Baugruppe. Dabei ist die Wärmeableitplatte 6 weggelassen. Das Substrat 2 der Halbleiterbaugruppe 10 ist hier direkt mittels der Ausgleichsschicht 5 mit dem Kühlkörper 3 verbunden. Auch hier ist die Ausgleichsschicht 5 wiederum aus einem präkeramischen Polymer hergestellt, welches zweckmäßigerweise mit einem Füllstoff gefüllt ist. Als Füllstoff wird vorteilhafterweise ein keramisches Material mit einer hohen Wärmeleitfähigkeit verwendet. Insbesondere bei hohen Füllgraden kann damit eine besonders hohe Wärmeleitfähigkeit der Ausgleichsschicht 5 erreicht werden.

Wegen der hervorragenden Wärmeleitfähigkeit der erfindungsgemäßen Ausgleichsschicht 5 ist es möglich, diese in größeren Schichtdicken als beispielsweise eine herkömmliche Wärmeleitpaste vorzusehen. Das wiederum ermöglicht einen vollständigen und zuverlässigen Ausgleich jeglicher Unebenheiten an der Kontaktfläche 5 und/oder der Wärmeableitfläche 7. Damit kann sichergestellt werden, dass die Ausgleichsschicht 5 vollflächig die Wärmeableitfläche 7 überdeckt und damit eine vollflächige Festkörperwärmeleitung von der Wärmeableitfläche 7 zur Kontaktfläche 4 gewährleistet ist. Damit eignet sich die erfindungsgemäße Ausgleichsschicht insbesondere zur Herstellung von Baugruppen mit Leistungshalbleitermodulen.

### Bezugszeichenliste

- 1: Leistungshalbleiter
- 2: Substrat
- 3: Kühlkörper
- 4: Kontaktfläche
- 5: Ausgleichsschicht
- 6: Wärmeableitplatte
- 7: Wärmeableitfläche
- 8: Verbindungsschicht
- 9: Oberseite
- 10: Halbleitermodul

## Patentansprüche

1. Baugruppe, bei der eine Wärmeableitfläche (7) eines Halbleitermoduls (10), insbesondere eines Leistungshalbleitermoduls, unter Zwischenschaltung einer wärmeleitenden Ausgleichsschicht (5) mit einer Kontaktfläche (4) eines Kühlkörpers (3) verbunden ist,
**dadurch gekennzeichnet, dass**
die wärmeleitende Ausgleichsschicht (5) eine aus einem präkeramischen Polymer gebildete Matrix aufweist.

2. Baugruppe nach Anspruch 1, wobei die Wärmeableitfläche (5) Bestandteil einer aus Metall, vorzugsweise aus Kupfer oder einer Kupferlegierung, hergestellten Wärmeableitplatte (6) ist.

3. Baugruppe nach einem der vorhergehenden Ansprüche, wobei zumindest ein Halbleiter (1), vorzugsweise ein Leistungshalbleiter, mittels einer aus einem weiteren präkeramischen Polymer hergestellten Verbindungsschicht (8) auf einer der wärmeableitenden Ausgleichsschicht (5) abgewandten Oberseite (9) der Wärmeableitplatte befestigt ist.

4. Baugruppe nach einem der vorhergehenden Ansprüche, wobei das präkeramische Polymer und/oder das weitere präkeramische Polymer mit einem Füllgrad von bis zu 80 Vol.% mit einem Füllstoff gefüllt ist.

5. Baugruppe nach einem der vorhergehenden Ansprüche, wobei der Füllstoff ein aus einem keramischen Material gebildetes Pulver mit einer mittleren Korngröße im Bereich von 0,5 bis 500 µm ist.

6. Baugruppe nach einem der vorhergehenden Ansprüche, wobei die Wärmeleitfähigkeit γ des keramischen Materials bei Raumtemperatur größer als 10 W/mK, vorzugsweise größer als 20 W/mK, ist.

7. Baugruppe nach einem der vorhergehenden Ansprüche, wobei das keramische Material aus der folgenden Gruppe ausgewählt ist: BN, SiC, Si₃N₄, Steatit, Cordierit.

8. Baugruppe nach einem der vorhergehenden Ansprüche, wobei das präkeramische Polymer und/oder das weitere präkeramische Polymer in gelartiger oder duroplastischer Form vorliegt.

9. Baugruppe nach einem der vorhergehenden Ansprüche, wobei das präkeramische Polymer und/oder das weitere präkeramische Polymer aus der folgenden Gruppe ausgewählt ist: Polysiloxan, Polysilazan, Polycarbosilan.

10. Verfahren zum Herstellung einer Baugruppe, bei der ein Halbleitermodul (10), insbesondere ein Leistungshalbleitermodul, mit einem Kühlkörper (3) verbunden ist, mit folgenden Schritten:
Auftragen eines fließfähigen präkeramischen Polymers auf eine Kontaktfläche (4) des Kühlkörpers (3) und/oder auf eine Wärmeableitfläche (7) des Halbleitermoduls (10),
Verbinden der Wärmeableitfläche (7) mit der Kontaktfläche (4), so dass sich dazwischen eine aus dem präkeramischen Polymer gebildete durchgehende Ausgleichsschicht (5) ausbildet, und
Vernetzen des präkeramischen Polymers, so dass dessen Viskosität sich zumindest um den Faktor 2 erhöht.

11. Verfahren nach Anspruch 10, wobei die Wärmeableitfläche (7) Bestandteil einer aus Metall, vorzugsweise aus Kupfer oder einer Kupferlegierung, hergestellten Wärmeableitplatte (6) ist.

12. Baugruppe nach einem der vorhergehenden Ansprüche, wobei zumindest ein Halbleiter (1), vorzugsweise ein Leistungshalbleiter, mittels einer mit einem weiteren präkeramischen Polymer hergestellten Verbindungsschicht (8) auf einer der wärmeableitenden Ausgleichsschicht (5) abgewandte Oberseite (9) die Wärmeableitplatte (6) befestigt wird.

13. Verfahren nach einem der Ansprüche 10 bis 12, wobei das fließfähige präkeramische Polymer und/oder das weitere präkeramische Polymer mittels einer Jetdüse, eines Nadeldispensers, Siebdruck oder Spritzen aufgetragen wird.

14. Verfahren nach einem der Ansprüche 10 bis 13, wobei das präkeramische Polymer und/oder das weitere präkeramische Polymer mit einem Füllgrad von bis zu 80 Vol.% mit einem Füllstoff gefüllt ist.

15. Verfahren nach Anspruch 14, wobei der Füllstoff ein aus einem keramischen Material gebildetes Pulver mit einer mittleren Korngröße im Bereich von 0,5 bis 500 µm ist.

16. Verfahren nach einem der Ansprüche 14 oder 15, wobei die Wärmeleitfähigkeit γ des keramischen Materials bei Raumtemperatur größer als 10 W/mK, vorzugsweise größer als 20 W/mK, ist.

17. Verfahren nach einem der Ansprüche 14 bis 16, wobei das keramische Material aus der folgenden Gruppe ausgewählt ist: BN, SiC, Si₃N₄, AlN, Steatit, Cordierit.

18. Verfahren nach einem der Ansprüche 10 bis 17, wobei das präkeramische Polymer und/oder das weitere präkeramische Polymer aus der folgenden Gruppe ausgewählt ist: ein Polysiloxan, Polysilazan, Polycarbosilan.
